# EUROPÄISCHE PATENTSCHRIFT

(11) **EP 1 816 233 B1**
(45) Veröffentlichungstag und Bekanntmachung des Hinweises auf die Patenterteilung: **17.12.2008**
(21) Anmeldenummer: 07008531.1
(22) Anmeldetag: 22.05.2001
(51) Int. Cl.: C23C 14/58, C23C 16/56, H01C 17/24, H03H 3/04

(54) **Verfahren zur Herstellung einer Schicht mit einem vorgegebenen Schichtdickenprofil**
Method for manufacturing a layer with a predefined layer thickness profile
Procédé de fabrication d'une couche dotée d'un profil d'épaisseur de couche prédéfini

(43) Veröffentlichungstag der Anmeldung: 08.08.2007
(62) Teilanmeldung aus: 01962685.2
(73) Patentinhaber: Infineon Technologies AG, 85579 Neubiberg (DE)
(72) Erfinder: AIGNER, Robert, 82008 Unterhaching (DE); MARKSTEINER, Stephan, 85640 Putzbrunn (DE); NESSLER, Winfried, 81739 München (DE); ELBRECHT, Lüder, 81825 München (DE); TIMME, Hans-Jörg, 85521 Ottobrunn (DE)
(74) Vertreter: Dilg, Haeusler, Schindelmann Patentanwaltsgesellschaft mbH

(56) Entgegenhaltungen:
- EP-A- 1 233 510
- EP-A- 1 258 990
- JP-A- 4 196 610
- JP-A- 7 073 834
- JP-A- 60 042 832
- JP-A- 61 137 327
- US-A- 4 075 452
- US-A- 4 457 803
- US-A- 5 266 529

## Beschreibung

Die Erfindung betrifft ein Verfahren zur Herstellung einer Schicht mit einem vorgegebenen bzw. angepaßten Schichtdickenprofil. Die Erfindung betrifft insbesondere ein Verfahren zur Herstellung einer Schicht mit einem vorgegebenen bzw. angepaßten Schichtdickenprofil zur Durchführung eines Frequenzabgleichs bei piezoelektrischen Schwingkreisen.

Die Eigenfrequenz von Schwingkreisen auf der Basis von piezoelektrischen Dünnfilmen im Frequenzbereich über 500 MHz ist indirekt proportional zur Schichtdicke der Piezoschicht. Der akustisch isolierende Unterbau sowie die Boden- und Deckelelektroden stellen eine zusätzliche Massenbelastung für den Schwingkreis dar, die eine Reduzierung der Eigenfrequenz bewirkt. Die Dickenschwankungen in allen diesen Schichten bestimmen den Bereich der Fertigungstoleranzen, in dem die Eigenfrequenz eines Exemplars des Schwingkreises liegt. Für Sputterprozesse in der Mikroelektronik sind Schichtdickenschwankungen von 5% typisch, mit einigem Aufwand können 1% (1σ) erreicht werden. Diese Schwankungen treten sowohl statistisch von Scheibe zu Scheibe als auch systematisch zwischen Scheibenmitte und Rand auf.

Die Dickentoleranzen der einzelnen Schichten im akustischen Pfad von Schwingkreisen auf der Basis von piezoelektrischen Dünnfilmen sind im wesentlichen stochastisch voneinander unabhängig. Die durch diese Dickentoleranzen verursachten Frequenzfehler bzw. -streuungen addieren sich daher nach dem Fehlerfortpflanzungsgesetz. Für Schwingkreise auf der Basis von piezoelektrischen Dünnfilmen ergibt sich dabei typisch eine Gesamtfrequenzstreuung von ca. 2% (1σ). Für Anwendungen im GHz-Bereich müssen jedoch die Eigenfrequenzen einzelner Schwingkreise zumindest eine absolute Genauigkeit von 0,5% aufweisen. In Hochpräzisionsanwendungen ergibt sich aus den Spezifikationen ein Toleranzfenster von nur 0.25%.

Für hochselektive Anwendungen müssen mehrere Schwingkreise in Leiter-, Gitter- oder Parallelkonfigurationen verschaltet werden. Die individuellen Schwingkreise müssen gezielt zueinander verstimmt werden, um die gewünschte Charakteristik zu erreichen. Vorzugsweise werden aus Kostengründen alle Schwingkreise eines Bauteils aus einer Piezoschicht konstanter Dicke hergestellt. Die Frequenzabstimmung erfolgt in der Regel durch additive Schichten in dem akustisch aktiven Stapel. Für jede vorkommende Eigenfrequenz muß eine Zusatzschicht unterschiedlicher Dicke hergestellt werden. Das erfordert in der Regel jeweils einen Abscheide- oder Ätzschritt, verbunden mit einem Lithografieschritt. Um diesen Aufwand zu begrenzen, werden üblicherweise nur Topologien hergestellt, mit denen nur zwei Eigenfrequenzen eingestellt werden.

In dem Dokument US 5,587,620 sind Verfahren beschrieben, bei denen durch eine Device-spezifische Abscheidung einer zusätzlichen Schicht ein Frequenzabgleich erreicht wird. Solche Verfahren, die nicht auf Waferebene durchgeführt werden können, sind jedoch mit vergleichsweise hohen Fertigungskosten verbunden. Weiterhin wird in dem Dokument US 5,587,620 ein Frequenzabgleich über eine Temperaturveränderungen vorgeschlagen. In dem Dokument EP 0 771 070 A2 wird ein Frequenzabgleich durch das Hinzuschalten weiterer passiver Komponenten erreicht. Leider weisen derartige Verfahren in der Regel einen zu geringen Frequenzeffekt auf bzw. führen zu anderen unerwünschten Veränderungen der Charakteristik des Schwingkreises.

Der vorliegenden Erfindung liegt daher die Aufgabe zugrunde, ein Verfahren zur Herstellung einer Schicht mit einem lokal angepaßtem bzw. vorgegebenen Schichtdickenprofil bereitzustellen, das die genannten Schwierigkeiten vermindert bzw. ganz vermeidet. Insbesondere liegt der vorliegenden Erfindung die Aufgabe zugrunde, ein Verfahren bereitzustellen, das zur Einstellung der Eigenfrequenzen von piezoelektrischen Schwingkreisen verwendet werden kann.

Diese Aufgabe wird von dem Verfahren zur Herstellung einer Schicht mit einem lokal angepaßtem bzw. vorgegebenen Schichtdickenprofil gemäß des unabhängigen Patentanspruchs 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Herstellung einer Schicht mit einem lokal angepaßtem bzw. vorgegebenen Schichtdickenprofil bereitgestellt, das die folgenden Schritte umfaßt:
a) zumindest eine Schicht wird auf ein Substrat aufgebracht,
b) ein Abtragsprofil wird für die aufgebrachten Schicht bestimmt, und
c) zumindest ein Ionenstrahl wird mit einer steuerbaren Geschwindigkeit relativ zu der Schicht zumindest einmal über die Schicht geführt, so daß am Ort des Ionenstrahls eine lokale Ätzung der Schicht entsprechend dem Abtragsprofil erfolgt und eine Schicht mit einem lokal angepaßtem bzw. vorgegebenen Schichtdickenprofil erzeugt wird.

Das erfindungsgemäße Verfahren besitzt den Vorteil, daß sowohl zufällige Schwankungen von Wafer zu Wafer als auch systematische Schwankungen zwischen Wafermitte und Waferrand korrigiert werden können. Das erfindungsgemäße Verfahren erlaubt eine kosteneffiziente Korrektur dieser Schwankungen mit vergleichsweise einfachem Equipment. Darüber hinaus kann das erfindungsgemäße Verfahren dazu verwendet werden, Schichten mit gezielt unterschiedlich dicken Bereichen herzustellen. Das erfindungsgemäße Verfahren besitzt zusätzlich den Vorteil, daß es universell für beliebige Schichtmaterialien und Schichtdicken einsetzbar ist. Weiterhin kann das erfindungsgemäße Verfahren mehrfach angewendet werden, falls das Abtragsprofil im ersten Versuch nicht erreicht werden konnte. Dabei profitiert der Maschinendurchsatz erheblich von Fortschritten, die sich in den Verfahren zur Schichtabscheidung ergeben.

Bevorzugt erfolgt die Bearbeitung der Schicht über den gesamten Wafer, wobei das erfindungsgemäße Verfahren an die Anforderungen, die durch eine industrielle Massenfertigung, beispielsweise hinsichtlich des Durchsatzes, vorgegeben sind, angepaßt ist. Die Bearbeitungszeit des erfindungemäßen Verfahren liegen im Bereich zwischen 1 und 60 Minuten.

Gemäß einer bevorzugten Ausführungsform der Erfindung wird das erfindungsgemäße Verfahren zur Einstellung der Eigenfrequenzen von piezoelektrischen Schwingkreisen verwendet. Auf diese Weise erhält man ein Verfahren, das eine direkte Einflußnahme auf die Eigenfrequenz erlaubt. Dabei ist das Verfahren vor, während und nach Fertigstellung des Schwingerstacks anwendbar. Es ist jedoch bevorzugt, wenn das Verfahren an einem bereits im wesentlichen fertiggestellten Schwingkreis durchgeführt wird. Darüber hinaus besitzt das erfindungsgemäße Verfahren den Vorteil, daß ein Frequenzabgleich auf Waferebene durchgeführt werden und daß die Eigenfrequenzen von piezoelektrischen Schwingkreisen über einen großen Trimmbereich von bis zu 20% eingestellt werden können.

Gemäß einer bevorzugten Ausführungsform der Erfindung ist die Ausdehnung des Ionenstrahls größer als 1 mm, bevorzugt größer als 5 mm. Weiterhin ist es bevorzugt, wenn die Ausdehnung des Ionenstrahls kleiner als 100 mm, bevorzugt kleiner als 50 mm ist.

Gemäß einer bevorzugten Ausführungsform der Erfindung wird als Ionenstrahl ein Argon-Ionenstrahl verwendet. Weiterhin ist es bevorzugt, wenn ein Ionenstrahl mit einer gaussförmigen Stromdichteverteilung verwendet wird. In diesem Fall wird die Halbwertsbreite des Ionenstrahls als Ausdehnung des Ionenstrahls verstanden. Dabei ist es insbesondere bevorzugt, wenn der Ionenstrahl in Spuren über die Schicht geführt wird und der Spurabstand kleiner als die Halbwertsbreite des Ionenstrahls ist.

Weiterhin ist es insbesondere bevorzugt, wenn ein Ionenstrahl mit einer homogenen Stromdichteverteilung verwendet wird. Dabei ist es insbesondere bevorzugt, wenn der Ionenstrahl in Spuren über die Schicht geführt wird und der Spurabstand kleiner als die Ausdehnung des Ionenstrahls ist. In beiden Fällen können somit die Steuerdaten für den Ionenstrahl, beispielsweise für den Verschiebetisch und die Quellensteuerung, aus einer inversen Faltung des gewünschten Abtragsprofils mit dem sogenannten "Ätz-Footprint" des Ionenstrahls gewonnen werden. Weiterhin ist es insbesondere bevorzugt, wenn die lokale Ätzung der Schicht durch die Stromdichte des Ionenstrahls gesteuert wird.

Gemäß einer weiteren bevorzugten Ausführungsform wird vor Schritt c) eine Maske, insbesondere eine Lackmaske, auf die Schicht aufgebracht, die nur die zu ätzenden Bereiche der Schicht offen läßt.

Wird das erfindungsgemäße Verfahren zur Einstellung von Eigenfrequenzen bei piezoelektrischen Schwingkreisen eingesetzt, so ist es insbesondere bevorzugt, wenn zur Bestimmung des Abtragsprofils der aufgebrachten Schicht eine elektrische Messung der Eigenfrequenz der piezoelektrischen Schwingkreise durchgeführt wird.

Die Erfindung wird nachfolgend anhand von Figuren der Zeichnung näher dargestellt. Es zeigen:
- Fig. 1: einen mit Hilfe des erfindungsgemäßen Verfahrens hergestellten piezoelektrischen Schwingkreis,
- Fig. 2 - 4: eine Ausführungsform des erfindungsgemäßen Verfahrens am Beispiel des Fig. 1 gezeigten, piezoelektrischen Schwingkreises,
- Fig. 5: ein typisches Abtragsprofil eines überwiegend rotationssymmetrischen Mitte-Rand-Fehlers in der Dicke einer Metallschicht,
- Fig. 6: ein gemessenes Abtragsprofil einer Ionenstrahlätzung, und
- Fig. 7 - 8: eine weitere Ausführungsform des erfindungsgemäßen Verfahrens.

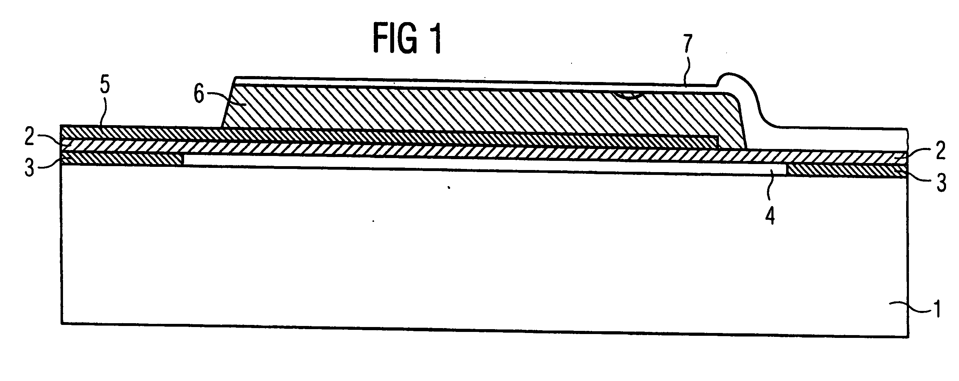

Fig. 1 zeigt einen mit Hilfe des erfindungsgemäßen Verfahrens hergestellten piezoelektrischen Schwingkreis. Auf einem Wafer 1 befindet sich eine Trägerschicht 2, die vorzugsweise Polysilizium ist und unter der sich im Bereich einer als Schwingkreis vorgesehenen Schichtstruktur ein Hohlraum 4 in einer Hilfsschicht 3 z. B. aus Oxid befindet. Der Hohlraum besitzt typisch die Abmessung von etwa 200 µm. Auf der Trägerschicht 2 befindet sich die Schichtstruktur des Schwingkreises aus einer für die Bodenelektrode vorgesehenen unteren Elektrodenschicht 5, einer Piezoschicht 6 und einer für die Deckelelektrode vorgesehenen oberen Elektrodenschicht 7. Die Elektrodenschichten 5, 7 sind vorzugsweise Metall, und die Piezoschicht 6 ist z. B. AlN, ZnO oder PZT-Keramik (PbZrTi). Diese Schichtstruktur besitzt insgesamt typisch die Dicke von etwa 5 µm. Anstatt des Hohlraums können auch andere akustisch isolierende Unterbauten, wie beispielsweise akustische Spiegel, verwendet werden.

Zur Einstellung einer der gewünschten Eigenfrequenz wurde die oberen Elektrodenschicht 7 mit einem lokal angepaßtem Dickenprofil erzeugt. Im vorliegenden Beispiel bedeutet dies, daß die oberen Elektrodenschicht 7 im Bereich des piezoelektrischen Schwingkreises direkt über der Piezoschicht 6 deutlich dünner ausgebildet als in den übrigen Bereichen. Dabei wurde das in Fig. 1 gezeigte Dickenprofil der oberen Elektrodenschicht 7 entsprechend einem erfindungsgemäßen Verfahren erzeugt.

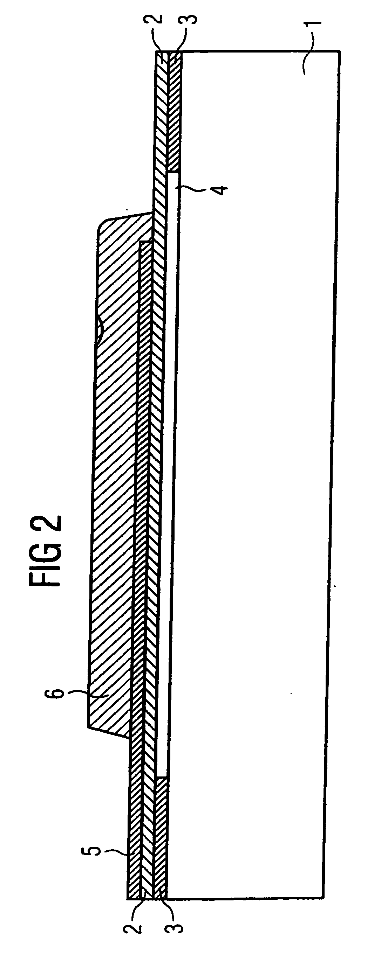

Die Figuren 2 bis 4 zeigen eine Ausführungsform des erfindungsgemäßen Verfahrens am Beispiel des in Fig. 1 gezeigten, piezoelektrischen Resonators. Der Ausgangspunkt ist dabei die in Fig. 2 gezeigte Struktur, die einem piezoelektrischen Schwingkreis ohne oberen Elektrodenschicht 7 entspricht. Die in Fig. 2 gezeigte Struktur wirkt somit als eine Art Substrat für die nachfolgende Abscheidung der oberen Elektrodenschicht 7.

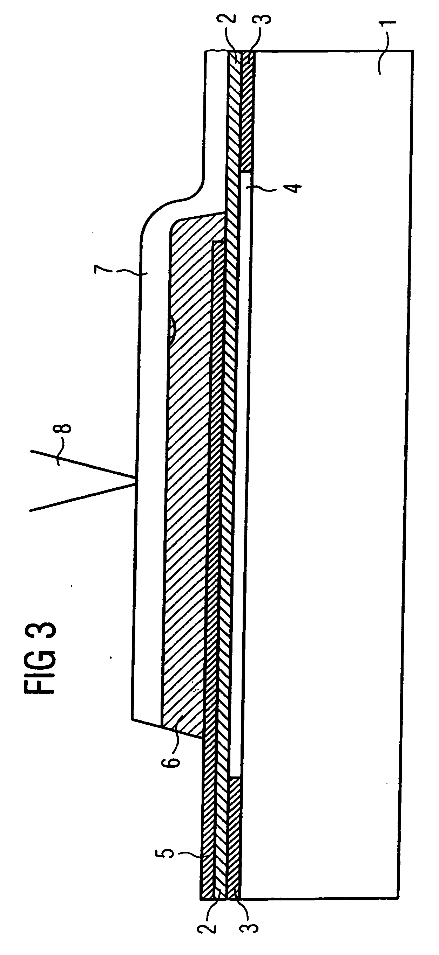

Anschließend wird durch ein Sputterverfahren ein relativ dicke Metallschicht, beispielsweise eine Wolfram-Schicht, erzeugt. Anstelle eines Sputterverfahrens kann auch ein CVD-Verfahren oder ein elektrochemisches Verfahren eingesetzt werden. Nach dem Aufbringen der Metallschicht wird das Abtragsprofil für das Metall bestimmt. Im vorliegenden Beispiel erfolgt diese Bestimmung am Ort des Schwingkreises durch eine Messung der Eigenfrequenz des Schwingkreises. Dazu wird ein Nadelkontakt 8 auf die Metallschicht geführt und die Impendanz des Schwingkreises in Abhängigkeit der Frequenz der elektrischen Anregung gemessen (Fig. 3). Aus der so gewonnenen Impedanzkurve kann die Eigenfrequenz bestimmt werden. Die gemessene Eigenfrequenz wird nun mit der gewünschten Eigenfrequenz für den piezoelektrischen Schwingkreis verglichen, wodurch der Teil der Schicht, der abgetragen werden muß, berechnet werden kann. Da dies bei unterschiedlichen Schwingkreisen auf dem Wafer 1 aufgrund der Dickenschwankungen der Schicht und/oder aufgrund von unterschiedlichen Funktionen der Schwingkreise unterschiedlich dicke Teile der Schicht sind, ergibt sich über den gesamten Wafer ein bestimmtes Abtragsprofil, das nachfolgend zur Steuerung des Ionenstrahlätzens verwendet wird.

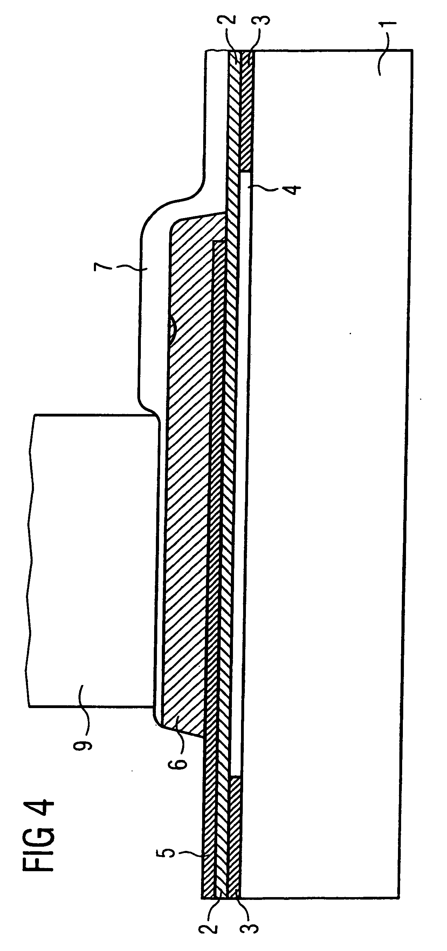

Anschließend wird ein Ionenstrahl 9 zumindest einmal über die Schicht geführt, so daß am Ort des Ionenstrahls eine lokale Ätzung der Metallschicht entsprechend dem Abtragsprofil erfolgt und eine Metallschicht 7 mit einem lokal an die gewünschte Eigenfrequenz des Schwingkreises angepaßten Schichtdickenprofil erzeugt wird (Fig. 4). Durch mechanisches Abrastern des Wafers mit einem gaussförmigen Ionenstrahl (der entsprechenden Durchmesser aufweist) kann ein lokal steuerbarer Abtrag realisiert werden. Wird der Wafer in Spuren abgescant, dann kann entweder der Strahlstrom oder die Scangeschwindigkeit entsprechend dem lokal benötigten Abtrag gesteuert werden. Das Abrastern erfolgt in beliebiger Folge aus Spuren in x- und y-Richtung (alternativ sind auch konzentrische Ringe oder Spiralen möglich), deren Spurabstand deutlich kleiner als die Halbwertsbreite des lonenstrahls ist.

Die Wahl des Strahldurchmessers erfolgt entsprechend des größten geforderten Abtragsgradienten; kleine Strahldurchmesser erlauben steilere Gradienten, ergeben jedoch global geringeren Volumenabtrag pro Zeiteinheit. Die Steuerdaten für den Verschiebetisch und die Quellensteuerung werden aus einer inversen Faltung des gewünschten Abtragsprofils mit dem sogenannten "Ätz-Footprint" des Ionenstrahls gewonnen.

Anstatt eines Ionenstrahl mit einer gaussförmigen Stromdichteverteilung kann natürlich auch ein Ionenstrahl mit einer homogenen Stromdichteverteilung verwendet werden. In diesem Fall sollte der Spurabstand kleiner als die Ausdehnung des Ionenstrahls sein.

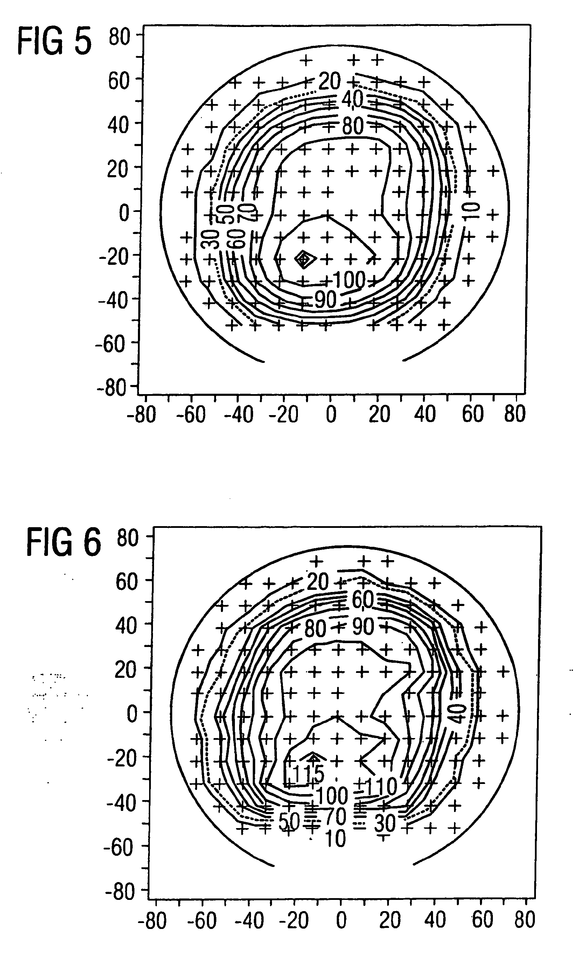

Fig. 5 zeigt ein typisches Abtragsprofil eines überwiegend rotationssymmetrischen Mitte-Rand-Fehlers in der Dicke einer Metallschicht, wie es aus einer elektrischen Frequenzmessung an ca. 150 Waferpositionen, entspricht 150 piezoelektrischen Schwingkreisen, berechnet werden kann. Fig. 6 zeigt das entsprechende, gemessenes Abtragsprofil einer Ionenstrahlätzung mit einem gaussförmigen Ar-Ionenstrahl (Halbwertsdurchmesser zwischen 5 und 50 mm), das mit einer Geschwindigkeitsteuerung in der x-Richtung erzielt wurde. Der Spurabstand in y-Richtung betrug etwa 10% des Halbwertsdurchmessers. Der verbleibende Fehler lag im Bereich zwischen 1 und 20 nm. Das erfindungsgemäße Verfahren besitzt den Vorteil, daß ein Frequenzabgleich auf Waferebene durchgeführt werden kann und daß die Eigenfrequenzen von piezoelektrischen Schwingkreisen über einen großen Trimmbereich von bis zu 20% und einer Frequenzgenauigkeit von 0.25% eingestellt werden können.

Bei der bisher beschriebenen Ausführungsform des erfindungsgemäßen Verfahrens wurde eine Schicht mit einem lokal an die gewünschte Eigenfrequenz der Schwingkreise angepaßtem Schichtdickenprofil erzeugt. Die Anpassung des Schichtdickenprofils muß jedoch nicht notwendigerweise in Hinblick auf die Eigenfrequenz eines Schwingkreises erfolgen. Mit dem erfindungsgemäßen Verfahren kann beispielsweise auch eine Vielzahl von Widerständen und/oder Kondensatoren mit unterschiedlichen Impedanzwerten aber gleichen lateralen Abmessungen erzeugt werden. Das erfindungsgemäße Verfahren wird dann dazu genutzt ein an den jeweiligen Widerstand bzw. Kondensator lokal angepaßtes Schichtdickenprofil zu erzeugen. Weiterhin kann mit dem erfindungsgemäßen Verfahren eine Vielzahl von Membranen mit unterschiedlichen mechanischen Parametern aber gleichen lateralen Abmessungen erzeugt werden. Das erfindungsgemäße Verfahren wird dann dazu genutzt ein an die jeweilige Membran angepaßtes Schichtdickenprofil des Membranmaterials zu erzeugen.

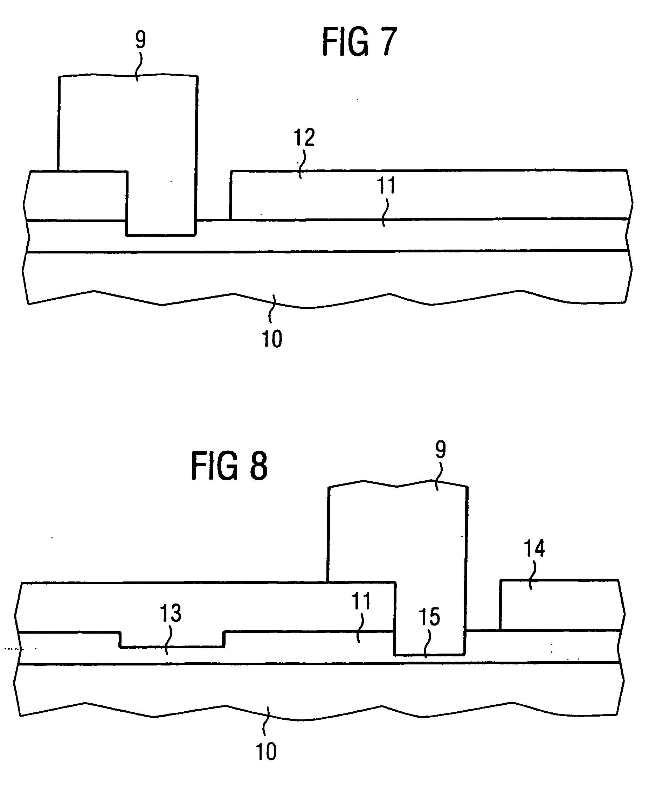

Die Figuren 7 - 8 zeigen eine weitere Ausführungsform des erfindungsgemäßen Verfahrens. Auf ein Substrat 10 wird ein relativ dicke Schicht 11 erzeugt. Anstelle eines Sputterverfahrens kann auch ein CVD-Verfahren oder ein elektrochemisches Verfahren eingesetzt werden. In Abhängigkeit der gewünschten Anwendung kann das Substrat 10 eine isolierende Schicht, beispielsweise eine Oxidschicht, und die Schicht 11 eine leitende Schicht, beispielsweise eine Metallschicht, sein. Eine derartige Wahl der Materialien wäre beispielsweise für die Erzeugung von Widerständen mit vorgegebenen, unterschiedlichen Widerstandswerten geeignet. Sollen hingegen Kondensatoren mit vorgegebenen, unterschiedlichen Impedanzwerten erzeugt werden, so würde als Substrat 10 eine leitende Schicht, beispielsweise eine Metallschicht, und als Schicht 11 eine isolierende Schicht, beispielsweise eine Oxidschicht, gewählt werden.

Nach dem Aufbringen der Schicht 11 und einer möglichen Strukturierung der Schicht 11 wird das Abtragsprofil für die Schicht 11 bestimmt. Für den Fall, daß Widerständen mit vorgegebenen, unterschiedlichen Widerstandswerten erzeugt werden sollen, kann das Abtragsprofil beispielsweise mit einer Widerstandsmessung bestimmt werden. Es können jedoch auch interferometrische Messungen eingesetzt werden.

Das vorliegende Beispiel geht davon aus, daß verteilt über den Wafer Widerstände mit zwei unterschiedlichen Widerstandswerten erzeugt werden sollen. Daher wird anschließend eine Lackschicht aufgebracht und entwickelt, so daß eine Lackmaske 12 entsteht, welche an den Stellen geöffnet ist, an denen die Widerstände 13 mit einem ersten Widerstandswert erzeugt werden sollen. Anschließend erfolgt eine Ionenstrahlätzung, die an den geöffneten Stellen der Lackmaske 12 eine Ätzung entsprechend dem vorgegebenen Abtragsprofil mit einem Ionenstrahl 9 durchführt. Alle übrigen Bereiche der Schicht 11 werden dabei durch die Lackmaske 12 geschützt (Fig. 7).

Ist die erste Ionenstrahlätzung abgeschlossen, wird die Lackmaske 12 entfernt und eine weitere Lackschicht aufgebracht und entwickelt, so daß eine weitere Lackmaske 14 entsteht, welche an den Stellen geöffnet ist, an denen die Widerstände 15 mit einem zweiten Widerstandswert erzeugt werden sollen. Anschließend erfolgt wiederum eine Ionenstrahlätzung, die an den geöffneten Stellen der Lackmaske 14 eine Ätzung entsprechend dem vorgegebenen Abtragsprofil durchführt. Alle übrigen Bereiche der Schicht 11 werden dabei durch die Lackmaske 14 geschützt (Fig. 8). Nach der Entfernung der Lackmaske 14 erhält man eine somit eine Schicht 11 mit einem an den jeweiligen Widerstand lokal angepaßtem Schichtdickenprofil.

## Patentansprüche

1. Verfahren zur Herstellung einer Schicht mit einem lokal angepasstem bzw. vorgegebenen Schichtdickenprofil mit den schritten:
a) zumindest eine Schicht wird auf ein Substrat aufgebracht,
b) ein Abtragsprofil für die aufgebrachte Schicht wird bestimmt, und
c) zumindest ein Ionenstrahl wird mit einer steuerbaren Geschwindigkeit relativ zu der Schicht zumindest einmal über die Schicht geführt, so dass am Ort des Ionenstrahls eine lokale Ätzung der Schicht entsprechend dem Abtragsprofil erfolgt und eine Schicht mit einem lokal angepasstem bzw. vorgegebenen Schichtdickenprofil erzeugt wird.

2. Verfahren nach Anspruch 1,
**dadurch gekennzeichnet , daß**
die Ausdehnung des Ionenstrahls größer als 1 mm, bevorzugt größer als 5 mm ist.

3. Verfahren nach Anspruch 1 oder 2,
**dadurch gekennzeichnet , daß**
die Ausdehnung des Ionenstrahls kleiner als 100 mm, bevorzugt kleiner als 50 mm ist.

4. Verfahren nach einem der Ansprüche 1 bis 3,
**dadurch gekennzeichnet , daß**
als Ionenstrahl ein Argon-Ionenstrahl verwendet wird.

5. Verfahren nach einem der Ansprüche 1 bis 4,
**dadurch gekennzeichnet , daß**
ein Ionenstrahl mit einer gaussförmigen Stromdichteverteilung verwendet wird.

6. Verfahren nach Anspruch 5,
**dadurch gekennzeichnet , daß**
der Ionenstrahl in Spuren über die Schicht geführt wird und der Spurabstand kleiner als die Halbwertsbreite des Ionenstrahls ist.

7. Verfahren nach einem der Ansprüche 1 bis 4,
**dadurch gekennzeichnet , daß**
ein Ionenstrahl mit einer homogenen Stromdichteverteilung verwendet wird.

8. Verfahren nach Anspruch 7,
**dadurch gekennzeichnet , daß**
der Ionenstrahl in Spuren über die Schicht geführt wird und der Spurabstand kleiner als die Ausdehnung des Ionenstrahls ist.

9. Verfahren nach einem der Ansprüche 1 bis 8,
**dadurch gekennzeichnet , daß**
die lokale Ätzung der Schicht durch die Stromdichte des Ionenstrahls gesteuert wird.

10. Verfahren nach einem der Ansprüche 1 bis 9,
**dadurch gekennzeichnet , daß**
vor Schritt c) eine Maske, insbesondere eine Lackmaske, auf die Schicht aufgebracht wird, die nur die zu ätzenden Bereiche der Schicht offen läßt.

11. Verfahren nach einem der Ansprüche 1 bis 10,
**dadurch gekennzeichnet , daß**
das Verfahren zur Einstellung der Eigenfrequenzen von piezoelektrischen Schwingkreisen verwendet wird.

12. Verfahren nach Anspruch 11,
**dadurch gekennzeichnet , daß**
zur Bestimmung des Abtragsprofils für die aufgebrachte Schicht eine elektrische Messung der Eigenfrequenzen der piezoelektrischen Schwingkreise durchgeführt wird.

13. Verfahren nach einem der Ansprüche 1 bis 10,
**dadurch gekennzeichnet , daß**
das Verfahren zur Einstellung der Impendanzen von Widerständen und/oder Kondensatoren verwendet wird.

14. Verfahren nach einem der Ansprüche 1 bis 10,
**dadurch gekennzeichnet , daß**
das Verfahren zur Erzeugung einer Vielzahl von Membranen mit unterschiedlichen mechanischen Parametern verwendet wird.

## Claims

1. Method for producing a layer with a locally adapted or predefined layer thickness profile having the following steps:
a) at least one layer is applied to a substrate,
b) a removal profile is determined for the applied layer, and
c) at least one ion beam is guided with a controllable speed relative to the layer, over the layer at least once, so that, at the location of the ion beam, the layer is etched locally in accordance with the removal profile and a layer with a locally adapted or predefined layer thickness profile is produced.

2. Method according to Claim 1,
**characterized in that**
the extent of the ion beam is greater than 1 mm, preferably greater than 5 mm.

3. Method according to Claim 1 or 2,
**characterized in that**
the extent of the ion beam is less than 100 mm, preferably less than 50 mm.

4. Method according to one of Claims 1 to 3,
**characterized in that**
an argon ion beam is used as the ion beam.

5. Method according to one of Claims 1 to 4,
**characterized in that**
an ion beam with a Gaussian current density distribution is used.

6. Method according to Claim 5,
**characterized in that**
the ion beam is guided over the layer in tracks and the track spacing is less than the half-value width of the ion beam.

7. Method according to one of Claims 1 to 4,
**characterized in that**
an ion beam with a homogeneous current density distribution is used.

8. Method according to Claim 7,
**characterized in that**
the ion beam is guided over the layer in tracks and the track spacing is less than the extent of the ion beam.

9. Method according to one of Claims 1 to 8,
**characterized in that**
the local etching of the layer is controlled by the current density of the ion beam.

10. Method according to one of Claims 1 to 9,
**characterized in that**
before step c), a mask, in particular a resist mask, is applied to the layer, which leaves open only the regions of the layer which are to be etched.

11. Method according to one of Claims 1 to 10,
**characterized in that**
the method is used for setting the natural frequencies of piezoelectric resonant circuits.

12. Method according to Claim 11,
**characterized in that**
an electrical measurement of the natural frequencies of the piezoelectric resonant circuits is carried out in order to determine the removal profile for the applied layer.

13. Method according to one of Claims 1 to 10,
**characterized in that**
the method is used for setting the impedances of resistors and/or capacitors.

14. Method according to one of Claims 1 to 10,
**characterized in that**
the method is used for producing a multiplicity of diaphragms with different mechanical parameters.

## Revendications

1. Procédé de production d'une couche ayant un profil d'épaisseur adapté ou prescrit localement, dans lequel :
a) on dépose au moins une couche sur un substrat,
b) on détermine un profil d'enlèvement de la couche déposée, et
c) on envoie au moins un faisceau d'ions, ayant une vitesse qui peut être réglée par rapport à la couche, au moins une fois sur la couche de manière à produire à l'emplacement du faisceau d'ions une attaque locale de la couche conforme au profil d'enlèvement et à produire une couche ayant un profil d'épaisseur adapté ou prescrit localement.

2. Procédé selon la revendication 1, **caractérisé en ce que** l'étendue du faisceau d'ions est plus grande que 1 mm, de préférence plus grande que 5 mm.

3. Procédé selon la revendication 1 ou 2, **caractérisé en ce que** l'étendue du faisceau d'ions est plus petite que 100 mm, de préférence plus petite que 50 mm.

4. Procédé selon l'une des revendications 1 à 3, **caractérisé en ce que** l'on utilise comme faisceau d'ions un faisceau d'ions d'argon.

5. Procédé selon l'une des revendications 1 à 4, **caractérisé en ce que** l'on utilise un faisceau d'ions ayant une répartition gaussienne de la densité de courant.

6. Procédé selon la revendication 5, **caractérisé en ce que** l'on envoie le faisceau d'ions en traces sur la couche et la distance entre les traces est plus petite que la largeur de valeur moyenne du faisceau d'ions.

7. Procédé selon l'une des revendications 1 à 4, **caractérisé en ce que** l'on utilise un faisceau d'ions ayant une répartition homogène de la densité de courant.

8. Procédé selon la revendication 7, **caractérisé en ce que** l'on envoie le faisceau d'ions en traces sur la couche et la distance entre les traces est plus petite que l'étendue du faisceau d'ions.

9. Procédé selon l'une des revendications 1 à 8, **caractérisé en ce que** l'on règle l'attaque locale de la couche par la densité de courant du faisceau d'ions.

10. Procédé selon l'une des revendications 1 à 9, **caractérisé en ce qu'**avant le stade c) on dépose un masque, notamment un masque de vernis, sur la couche, masque qui ne laisse dégagées que les parties de la couche à attaquer.

11. Procédé selon l'une des revendications 1 à 10, **caractérisé en ce que** l'on utilise le procédé pour régler la fréquence propre de circuits oscillants piézoélectriques.

12. Procédé selon la revendication 11, **caractérisé en ce que**, pour déterminer le profil d'enlèvement de la couche déposée, on effectue une mesure électrique des fréquences propres des circuits oscillants piézoélectriques.

13. Procédé selon l'une des revendications 1 à 10, **caractérisé en ce que** l'on utilise le procédé pour régler l'impédance de résistances et/ou de condensateurs.

14. Procédé selon l'une des revendications 1 à 10, **caractérisé en ce que** l'on utilise le procédé pour produire une pluralité de membranes ayant des paramètres mécaniques différents.
